# EUROPEAN PATENT APPLICATION

(11) **EP 4 517 395 A1**
(43) Date of publication of application: **05.03.2025**
(21) Application number: 24195010.4
(22) Date of filing: 16.08.2024
(51) Int. Cl.: G02B 3/14, H10N 30/80

(54) **PIEZOELECTRIC ACTUATOR WITH CAPACITANCE SENSING FOR OPTICAL POWER CONTROL**

(30) Priority: 28.08.2023 US 202363579227 P; 18.07.2024 US 202418776689
(71) Applicant: Meta Platforms Technologies, LLC, Menlo Park, CA 94025 (US)
(72) Inventor: Huang, Lidu, Menlo Park (US); Finkelstein, Hod, Menlo Park, 94025 (US); Xiong, Shaomin, Menlo Park, 94025 (US); Xie, Qiulin, Menlo Park, 94025 (US)
(74) Representative: Murgitroyd & Company

(57) **Abstract**

A method of operating a tunable lens includes determining a relationship between the optical power of a tunable lens and the capacitance of a piezoelectric element configured to deform the tunable lens, measuring the capacitance of the piezoelectric element, and applying a driving voltage to the piezoelectric element based on the measured capacitance to induce a desired optical power in the tunable lens.

## Description

This invention relates to a method of operating a tunable lens.

### SUMMARY

According to an aspect, there is provided a method comprising:
determining a relationship between the optical power of a tunable lens and the capacitance of a piezoelectric element configured to deform the tunable lens;
measuring the capacitance of the piezoelectric element; and
applying a driving voltage to the piezoelectric element based on the measured capacitance to induce a desired optical power in the tunable lens.

In one embodiment, determining the relationship between the optical power and the capacitance comprises evaluating at least two conditions selected from the group consisting of an initial optical power of the tunable lens, piezoelectric hysteresis of the piezoelectric element, thermal drift of the optical power, and viscoelastic creep of a component of the tunable lens.

In one embodiment, the method comprises applying a sensing voltage to the piezoelectric element while applying the driving voltage.

In one embodiment, applying the driving voltage comprises:
applying a first driving voltage to the piezoelectric element to generate a first optical power in the tunable lens;
applying a reset voltage less than the first driving voltage to the piezoelectric element to reset the tunable lens; and
applying a second driving voltage less than the first driving voltage to the piezoelectric element to generate a second optical power in the tunable lens.

In one embodiment, applying the driving voltage comprises:
applying a first driving voltage to the piezoelectric element to generate a first optical power in the tunable lens;
applying a second driving voltage greater than the first driving voltage to the piezoelectric element to generate a second optical power in the tunable lens;
applying a reset voltage less than the first driving voltage to the piezoelectric element to reset the tunable lens; and
applying a third driving voltage less than the second driving voltage to the piezoelectric element to generate a third optical power in the tunable lens.

According to another aspect, there is provided a method comprising:
applying a first driving voltage to a piezoelectric element to generate a first optical power in a tunable lens;
applying a reset voltage less than the first driving voltage to the piezoelectric element to reset the tunable lens; and
applying a second driving voltage to the piezoelectric element to generate a second optical power in the tunable lens, wherein the second driving voltage is less than the first driving voltage.

In one embodiment, applying the reset voltage comprises applying zero volts or a negative voltage to the piezoelectric element.

In one embodiment, the first optical power is less than the second optical power.

In one embodiment, the method comprises applying a sensing voltage to the piezoelectric element while applying the first driving voltage and the second driving voltage.

In one embodiment, the method comprises sensing a capacitance of the piezoelectric element.

In one embodiment, the first and second driving voltages are determined from respective capacitance measurements of the piezoelectric element.

According to a further aspect, there is provided a method comprising:
applying a first driving voltage to a piezoelectric element to generate a first optical power in a tunable lens;
applying a second driving voltage greater than the first driving voltage to the piezoelectric element to generate a second optical power in the tunable lens;
applying a reset voltage less than the first driving voltage to the piezoelectric element to reset the tunable lens; and
applying a third driving voltage less than the second driving voltage to the piezoelectric element to generate a third optical power in the tunable lens.

In one embodiment, applying the reset voltage comprises applying zero volts or a negative voltage to the piezoelectric element.

In one embodiment, the third driving voltage is greater than the first driving voltage.

In one embodiment, the third driving voltage is less than the second driving voltage.

In one embodiment, the second optical power is greater than the first optical power.

In one embodiment, the third optical power is less than the first optical power.

In one embodiment, the method comprises applying a sensing voltage to the piezoelectric element while applying the first driving voltage, the second driving voltage, and the third driving voltage.

In one embodiment, the method comprises sensing a capacitance of the piezoelectric element.

In one embodiment, the first, second, and third driving voltages are determined from respective capacitance measurements of the piezoelectric element.

It will be appreciated that any features described herein as being suitable for incorporation into one or more aspects or embodiments of the present disclosure are intended to be generalizable across any and all aspects and embodiments of the present disclosure. Other aspects of the present disclosure can be understood by those skilled in the art in light of the description, the claims, and the drawings of the present disclosure. The foregoing general description and the following detailed description are exemplary and explanatory only and are not restrictive of the claims.

### BRIEF DESCRIPTION OF THE DRAWINGS

The accompanying drawings illustrate a number of exemplary embodiments and are a part of the specification. Together with the following description, these drawings demonstrate and explain various principles of the present disclosure.
FIG. 1 illustrates various sources of non-linearity in the operation of a lens driven by a piezoelectric actuator according to some embodiments.
FIG. 2 depicts an optical model for determining a voltage profile for generating a target optical power in a lens controlled by a piezoelectric actuator according to various embodiments.
FIG. 3 is an example circuit diagram for implementing the optical model of FIG. 2 according to some embodiments.
FIG. 4 is a plot of driving voltage superimposed with a capacitance measurement signal according to certain embodiments.
FIG. 5 depicts various methods for measuring the capacitance of a piezoelectric element according to some embodiments.
FIG. 6 is a simplified circuit diagram depicting a method for measuring capacitance according to some embodiments.
FIG. 7 is a schematic illustration of an example closed-loop control configuration for driving a piezoelectric actuator according to certain embodiments.
FIG. 8 depicts an approach for operating a piezoelectric actuator-controlled tunable lens according to some embodiments.
FIG. 9 is a cross-sectional illustration of a tunable lens operable through closed-loop control of one or more piezoelectric actuators according to various embodiments.
FIG. 10 is an isometric view of an example piezoelectric actuator according to some embodiments.
FIG. 11 is a plot of optical power versus applied voltage showing the hysteresis behavior for an optical model according to certain embodiments.
FIG. 12 is a plot of optical power versus applied voltage showing operation of a piezoelectric actuator-controlled tunable lens according to some embodiments.
FIG. 13 is a plot of optical power versus applied voltage showing operation of a piezoelectric actuator-controlled tunable lens according to some embodiments.
FIG. 14 is an illustration of exemplary augmented-reality glasses that may be used in connection with embodiments of this disclosure.
FIG. 15 is an illustration of an exemplary virtual-reality headset that may be used in connection with embodiments of this disclosure.

Throughout the drawings, identical reference characters and descriptions indicate similar, but not necessarily identical, elements. While the exemplary embodiments described herein are susceptible to various modifications and alternative forms, specific embodiments have been shown by way of example in the drawings and will be described in detail herein. However, the exemplary embodiments described herein are not intended to be limited to the particular forms disclosed. Rather, the present disclosure covers all modifications, equivalents, and alternatives falling within the scope of the appended claims.

### DETAILED DESCRIPTION OF EXEMPLARY EMBODIMENTS

There is a growing demand for optical systems having tunable focal lengths, including adaptive optics. For instance, adaptive optics technology may be incorporated into wearable devices such as augmented reality and virtual reality devices and headsets. Example architectures for actively changing the focal length of an optical system include large-scale deformable-optics devices, macro- and MEMS-scale translatable lenses, and electrostatically actuated devices. There remains a need, however, for high speed and consistent tuning of focal lengths over a wide tuning range, which has not been adequately addressed by the foregoing platforms.

Notwithstanding recent developments, it would be advantageous to provide an autofocusing solution for a tunable lens. The present disclosure relates generally to optical elements such as tunable lenses, and more specifically to a closed-loop control paradigm for predictably and reproducibly manipulating the optical power of a lens through capacitance sensing of an associated piezoelectric element.

For a tunable lens operable using a piezoelectrically-driven actuator, an optical model establishes a relationship between the optical power of the lens and the capacitance of the piezoelectric element. The model is configured to dynamically apply a waveform to the piezoelectric element in a manner effective to account for thermal and temporal variations in both optical power and capacitance to achieve a targeted focus condition. Accordingly, the system optical power can be tuned real-time via closed-loop control using the capacitance of the piezoelectric element. The closed-loop control can provide rapid and accurate focusing. This allows for the generation and maintenance of a high quality image in an associated display. Using the disclosed model, a relationship between system optical power and component optical power may be utilized to determine a reference capacitance for a specified focal condition.

In some approaches, an electronic circuit may be used to actively measure the capacitance of the piezoelectric element during use. A sensing excitation waveform and sampling frequency may be superimposed on the driving voltage in a non-interfering manner to enable closed-loop control. The driving voltage waveform may control the focal condition of the lens while avoiding overshoot and the creation of excessive stresses on the lens components, including its deformable glass membrane.

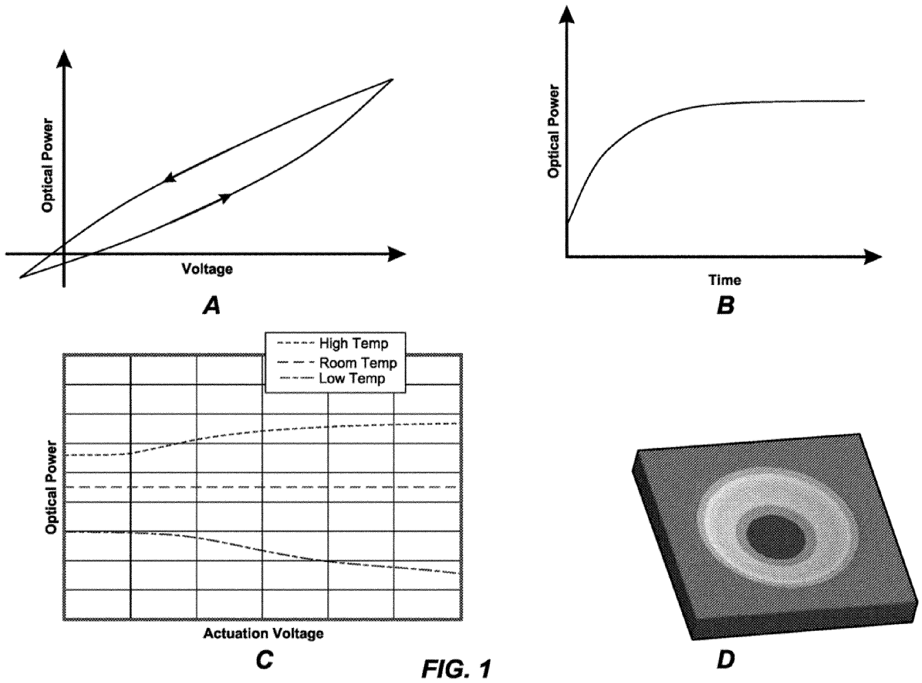

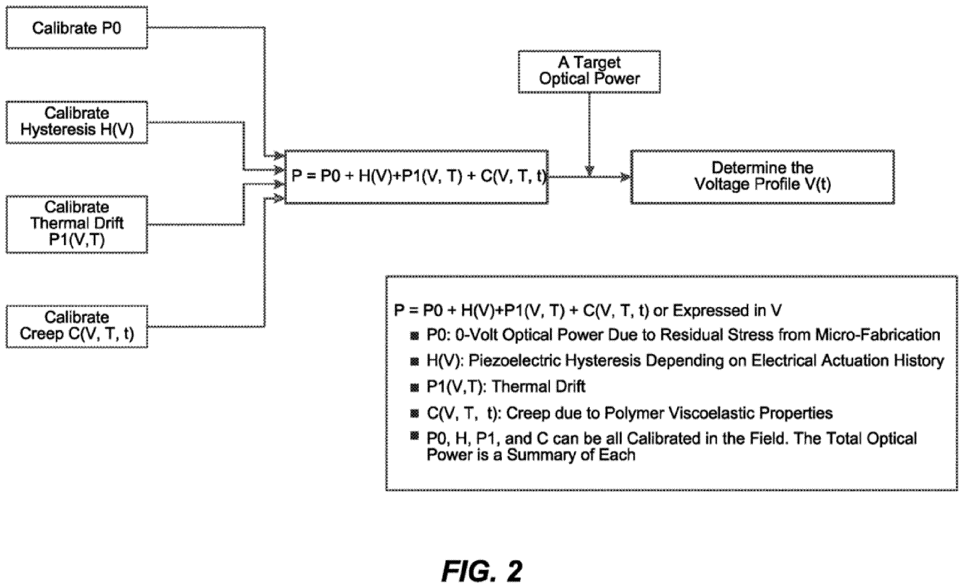

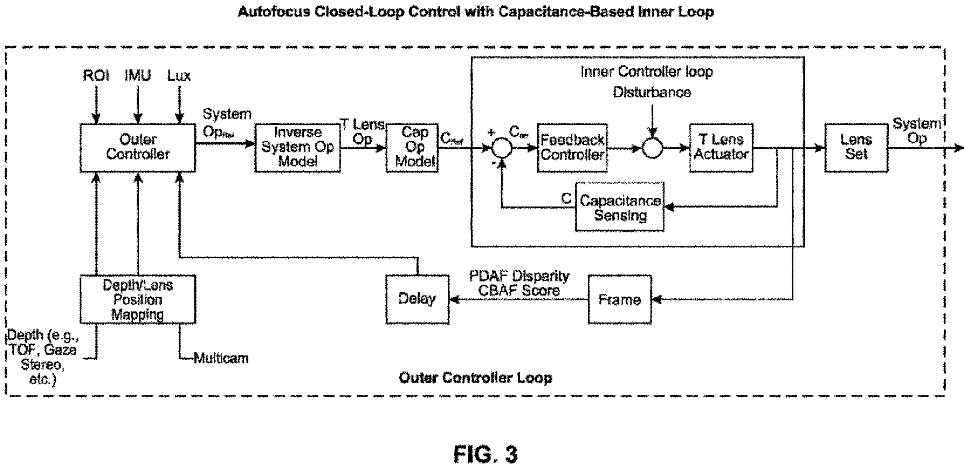

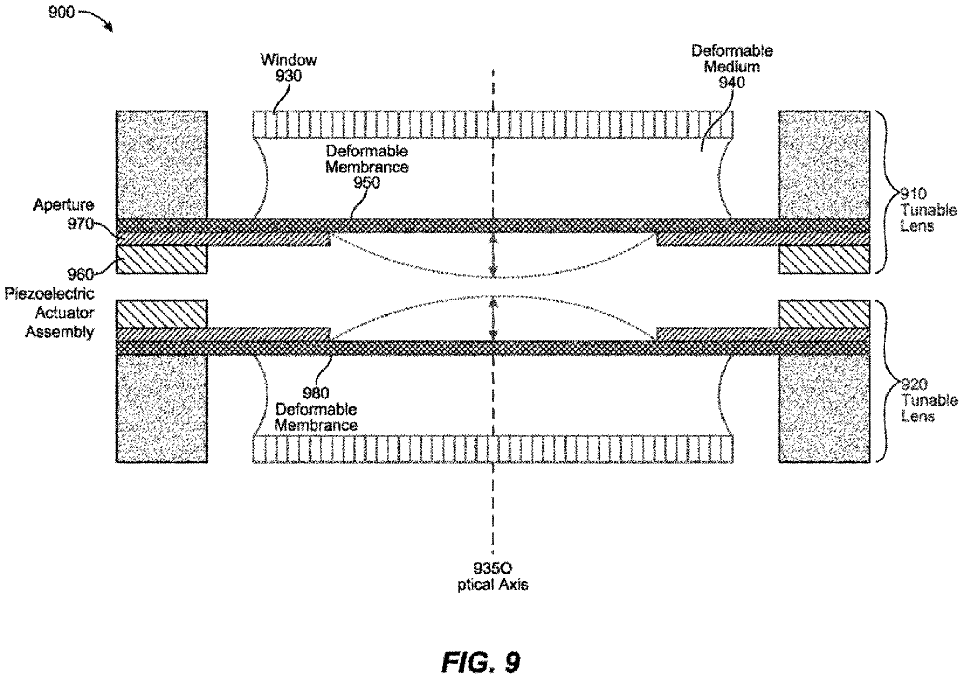

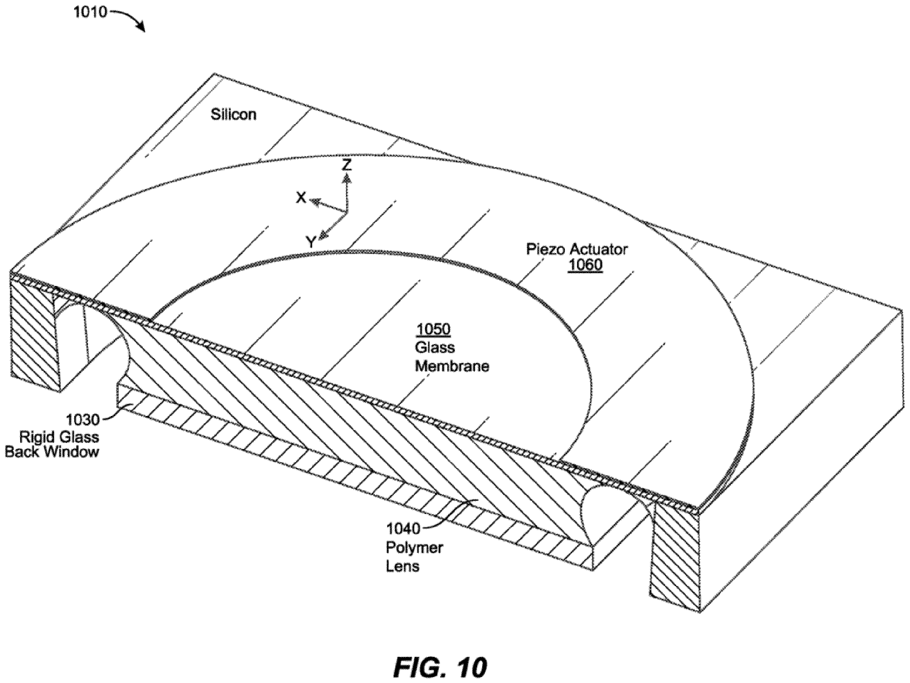

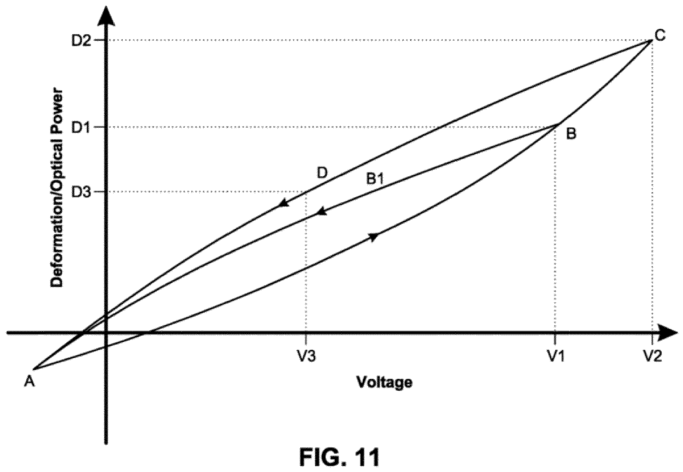

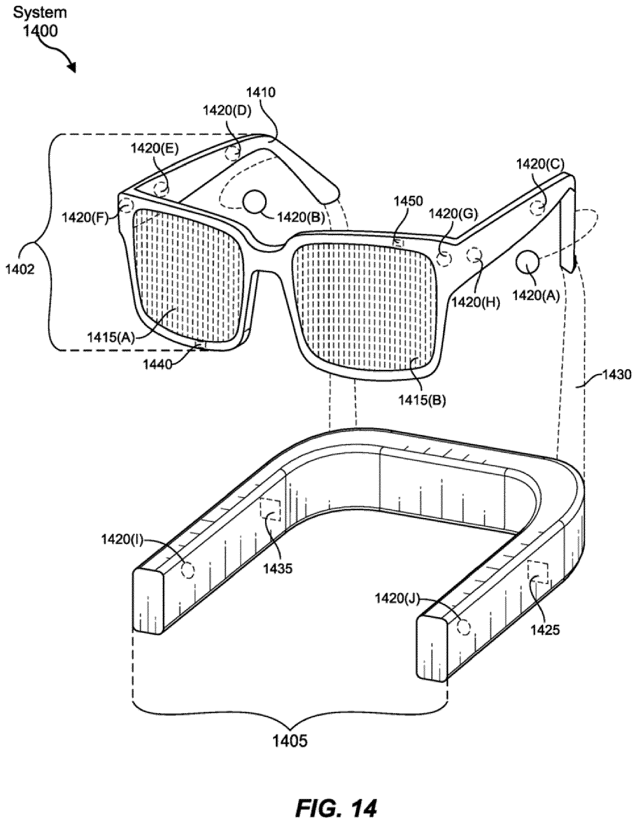

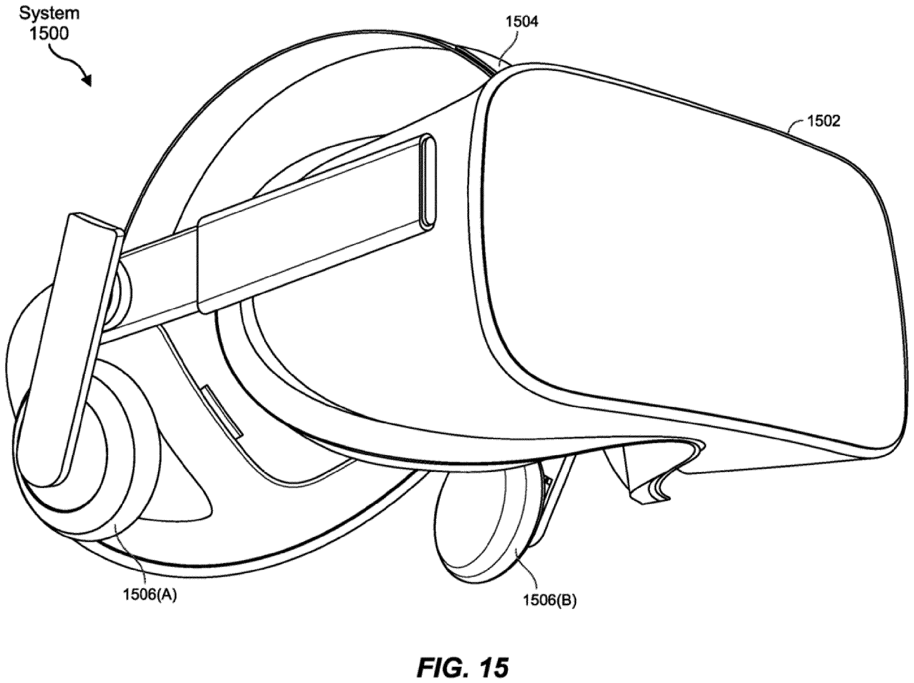

The following will provide, with reference to FIGS. 1-14, detailed descriptions of devices and related methods associated with the operation of a tunable lens. The discussion associated with FIG. 1 includes a description of various sources of optical power non-linearity in piezoelectrically driven lenses. The discussion associated with FIG. 2 includes a description of an optical model for accurate and precise control of a tunable lens. The discussion associated with FIGS. 3-8 includes a description of actuation and sensing architectures for controlling a piezoelectrically driven tunable lens. The discussion associated with FIGS. 9 and 10 includes a description of example tunable lens architectures. The discussion associated with FIGS. 11-13 includes a description of the operation of piezoelectric actuator-controlled tunable lenses. The discussion associated with FIGS. 14 and 15 relates to exemplary virtual reality and augmented reality devices that may include one or more piezoelectrically actuated tunable lenses as disclosed herein.

As will be appreciated, accurate and precise control of a piezoelectrically-actuated tunable lens may be complicated by a variety of effects. Sources of non-linearity are illustrated schematically in FIG. 1 and may include (A) piezoelectric hysteresis, (B) thermal drift, (C) creep, and (D) indigenous surface deformation, which may vary from lensto lens due to internal stresses and variability in manufacture. For example, piezoelectric hysteresis may contribute to optical power non-linearity when an increasing electric field is changed to a decreasing electric field, or vice versa. Disclosed herein is an optical model that may be implemented to consistently tune the optical power of a lens notwithstanding the foregoing challenges.

Referring to FIG. 2, an optical model uses capacitance sensing and incorporates various sources of non-linearity, including native optical power, to determine the driving waveform needed to induce the deformation required to generate a desired optical power in a tunable lens. For instance, a driving voltage profile (P) may be represented as a linear and weighted combination of terms related to native optical power (P0), piezoelectric hysteresis (H(V)), thermal drift (P1(V,T)), and viscoelastic creep C(V,T,t).

In various embodiments, the model may (i) determine a desired optical power from one or more of an applied voltage, operating time, and operating temperature, (ii) determine and evaluate a relationship between the actual optical power of the lens and the capacitance of the piezoelectric element, and (iii) measure the capacitance of the piezoelectric element to determine and apply a driving voltage effective to create the desired optical power.

Referring to FIG. 3, shown is a schematic diagram outlining closed-loop control of a piezoelectric actuator-driven lens. Included is an inner control loop for capacitance sensing, feedback, and actuation. Within a capacitance measurement circuit and during the calibration and/or use thereof, a relationship between optical power and capacitance may be established. An act of calibration may include (a) determining an initial optical power of the tunable lens, (b) for the initial optical power, evaluating the hysteresis behavior of the tunable lens as a function of applied voltage, (c) evaluating the thermal drift of the initial optical power as a function of applied voltage, (d) evaluating the creep behavior of the tunable lens for a given applied voltage, and (e) determining the relationship between module-level optical power and component-level optical power. As disclosed further herein, a variety of approaches may be used for capacitance sensing.

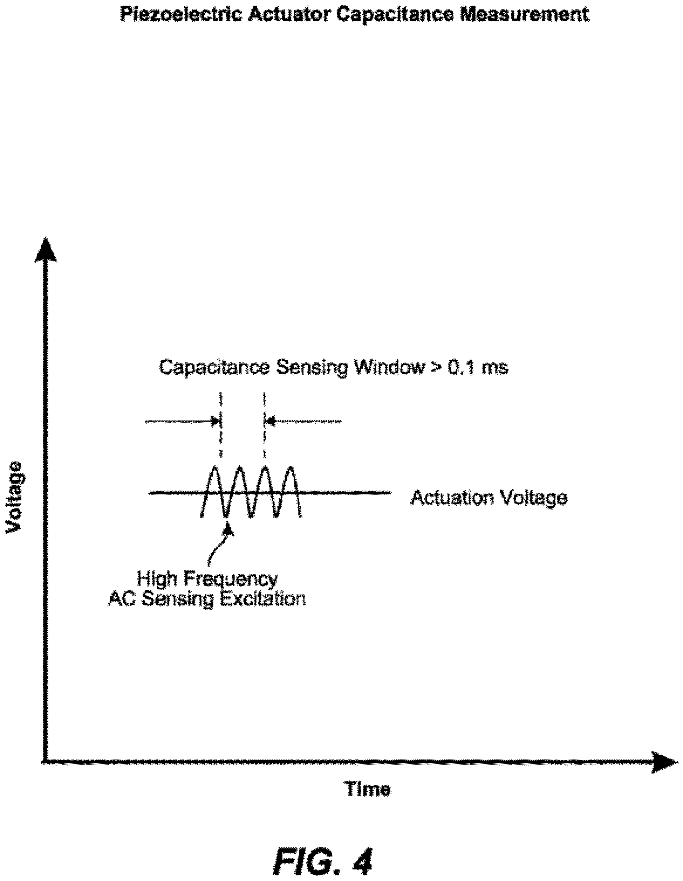

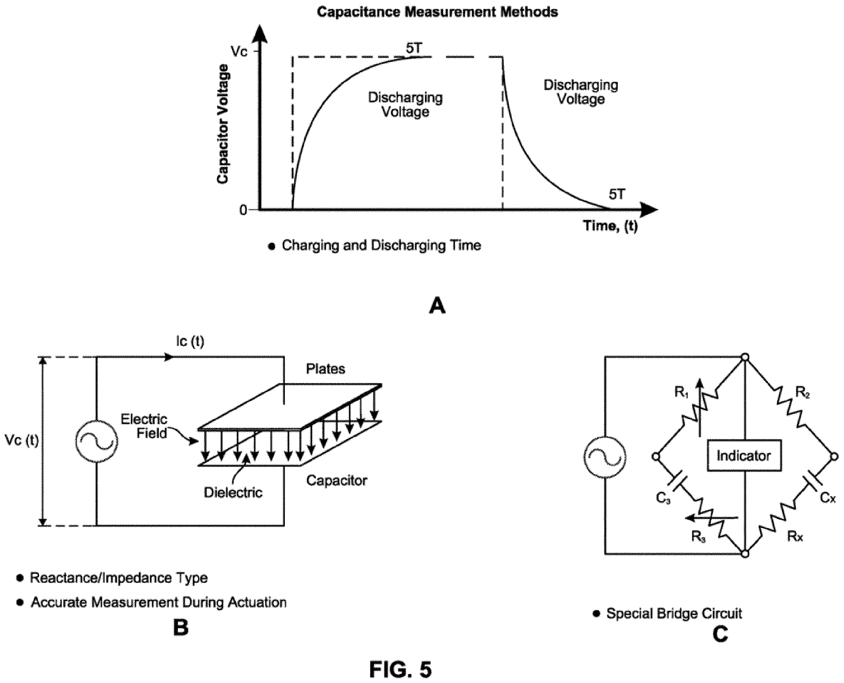

In accordance with some embodiments a constant voltage may be applied to a piezoelectric actuator to induce deformation of an associated lens and tune its optical power. As shown in FIG. 4, a low amplitude, high frequency AC signal for simultaneous capacitance sensing may be overlaid on the driving signal, and capacitance measurements may be taken within prescribed sampling windows. In certain embodiments, an AC waveform used for the capacitance measurement may be superimposed on a driving signal at a peak-to-peak amplitude of less than approximately 0.1 V and at a frequency (e.g., > 100 kHz) effective to avoid membrane resonance. A sampling rate may be chosen to measure the response of the piezoelectric layer. A sampling rate may range from approximately 10 kHz to approximately 50 kHz, for example, although when integrated with a low pass filter, higher sampling rates may be used. Selected capacitance sensing technologies are shown in FIG. 5, and may include (A) a charging and discharging time measurement, (B) a reactance/impedance-type measurement, or (C) a bridge-type measurement. By way of example, a reactance/impedance-type measurement may be configured to provide a large and nearly constant applied voltage for actuation of the piezoelectric element and a small but oscillating high frequency voltage for the capacitance measurement.

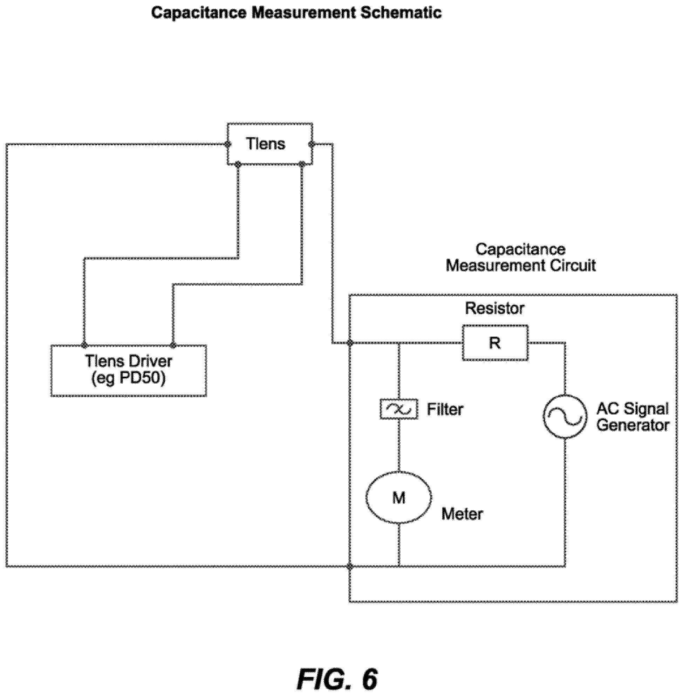

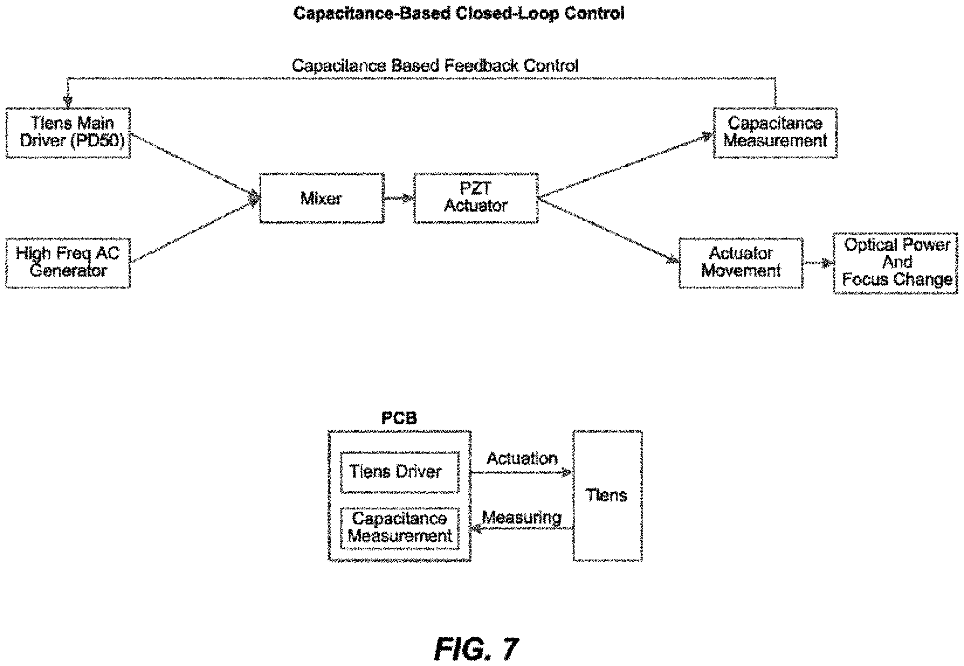

Turning to FIG. 6, depicted is an example impedance-based capacitance measuring scheme, which may include generating an AC signal, directing the AC signal to the piezoelectric element together with a driving signal, sensing the capacitance of the piezoelectric element through a modification of the AC signal, and measuring the capacitance by detecting the modified AC signal. A filter and meter may be used to isolate and measure the modified AC signal. A flowchart depicting actuator control co-integrated with capacitance sensing is shown in FIG. 7. In some embodiments, capacitance sensing and a voltage driver may be incorporated onto a single integrated circuit or printed circuit board.

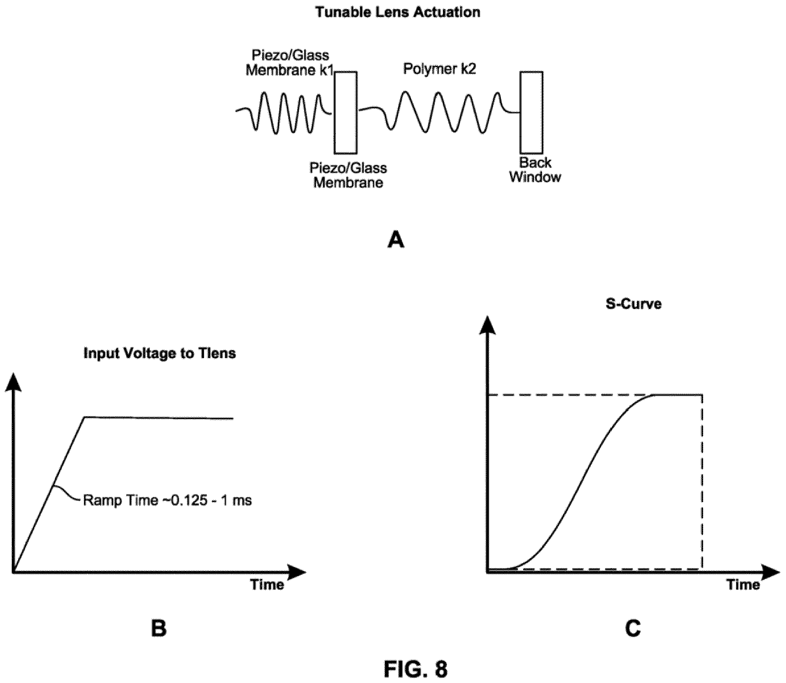

Referring to FIG. 8, according to some embodiments, driving and sensing signals may be configured to avoid mutual interference. As depicted in FIG. 8A, a lens actuator (e.g., PZT) may behave as an ultrasonic transducer/resonator (> 20 kHz) while a polymer layer may behave as a second resonator (^{~}8 kHz). Actuation of the lens between the two resonance peaks (8-20 kHz) may result in phase instability and the generation of large stresses in the glass membrane. However, with reference to FIG. 8B, the waveform used to actuate the lens may be engineered to avoid resonance, where the ramp time may range from approximately 0.125 ms to approximately 1 ms. A faster ramp time (e.g., 0.05 ms) may be used to intentionally induce performance overshoot, such as when a quick or sharp focus adjustment is desired. Turning to FIG. 8C, a smoothed waveform, such as an S-curve, may be applied, which may further decrease the propensity for exciting mechanical resonance modes. The duration of a smoothed (S-curve) type waveform may be approximately 0.1 to approximately 1.0 ms.

FIG. 9 is an example configuration of a tunable lens that has a range of optical powers that include both negative and positive values, according to one or more embodiments. The configuration 900 includes a tunable lens 910 and a tunable lens 920. The tunable lens 910 and the tunable lens 920 are in optical series with each other along optical axis 935. As illustrated the tunable lens 920 is substantially the same as the tunable lens 910, but is inverted relative to the tunable lens 910. Accordingly, the tunable lens 910 may have a positive range of optical power (e.g., 0 to +N diopters, where N is a number that is greater than or equal to zero) and the tunable lens 920 may have a negative range of optical power (e.g., 0 to -N). In alternate embodiments, the tunable lens 910 may differ from the tunable lens 920 such that they have different ranges of optical power (e.g., 0 to +N and 0 to -0.5 N, respectively). Likewise, in alternate embodiments, the tunable lens 920 may not be inverted relative to the tunable lens 910.

The tunable lens 910 may be configured to adjust its optical power in accordance with an applied signal. The tunable lens 910 includes a window 930, a deformable medium 940 (e.g., a polymer), a deformable membrane 950 (e.g., a deformable glass membrane), a piezoelectric actuator assembly 960, and an aperture 970. The piezoelectric actuator assembly 960 may include one or more piezoelectric actuators that are adapted to control a surface profile of the deformable membrane 950 responsive to an applied electrical signal (e.g., via an integrated electrode). As illustrated, the tunable lens 910 is in a first position in which the deformable membrane 950 is substantially flat (0 diopters) with respect to the optical axis 935. However, responsive to a received electrical signal the piezoelectric actuator assembly 960 applies one or more forces to the deformable membrane 950 to cause it to bend and introduce curvature into the surface profile of deformable membrane 950. In this manner, the optical power of tunable lens 910 may be adjusted from zero to +N diopters.

As noted above, the tunable lens 920 may be substantially the same as the tunable lens 910, but is inverted relative to the tunable lens 910. Accordingly, application of an electric signal to the tunable lens 920 (via its piezoelectric actuator assembly) causes a deformable membrane 980 to bend toward the tunable lens 910 introducing curvature into a surface profile of the deformable membrane 980. In this manner, the optical power of the tunable lens 920 may be dynamically adjusted from zero to -N diopters. Accordingly, the configuration 900 as shown has an optical range of (-N to +N) diopters.

A further example tunable lens configuration is shown in FIG. 10. Tunable lens 1010 includes a window 1030, a deformable medium 1040 (e.g., a polymer lens), a deformable membrane 1050 (e.g., a deformable glass membrane), and a piezoelectric actuator 1060 located peripheral to the membrane 1050.

Referring to FIG. 11, depicted is a pair of hysteresis loops showing the effect of applied voltage (i.e., applied voltage history) on the deformation and hence the optical power of a piezoelectric actuator-controlled tunable lens. As will be appreciated, the response functions of FIG. 11 may represent the combined effects of (A) piezoelectric hysteresis, (B) thermal drift, (C) creep, and (D) indigenous surface deformation.

The hysteresis loops of FIG. 11 include a major loop ABCDA, where point A may correspond to zero or finite applied voltage and/or zero or finite deformation. From point A, traveling along the major loop, the application of a positive applied voltage V1 may induce a deformation D1 associated with point B. From point B, and continuing along the major loop, the application of a positive voltage V2 may induce a deformation D2 (associated with point C). From point C, a decrease in the applied voltage to a value V3 may induce a deformation D3, as depicted as a return along the major loop to point D.

Accordingly, with reference to FIG. 11, an example method of operating a piezoelectric actuator-controlled tunable lens may include applying a first driving voltage to a piezoelectric actuator in an amount effective to generate a first optical power in the tunable lens and subsequently applying a second driving voltage greater than the first driving voltage to generate a second optical power in the tunable lens, where the second optical power is greater than the first optical power. The method may additionally include applying a third driving voltage less than the second driving voltage to generate a third optical power in the tunable lens, where the third optical power is less than the second optical power.

Applicants have shown that the relationship between applied voltage and deformation (or optical power) may be simplified by setting the applied voltage to a reset value in lieu of decreasing the applied voltage between successive set points, thus avoiding navigation along one of a multitude of minor loops (such as loop ABB1A in FIG. 11).

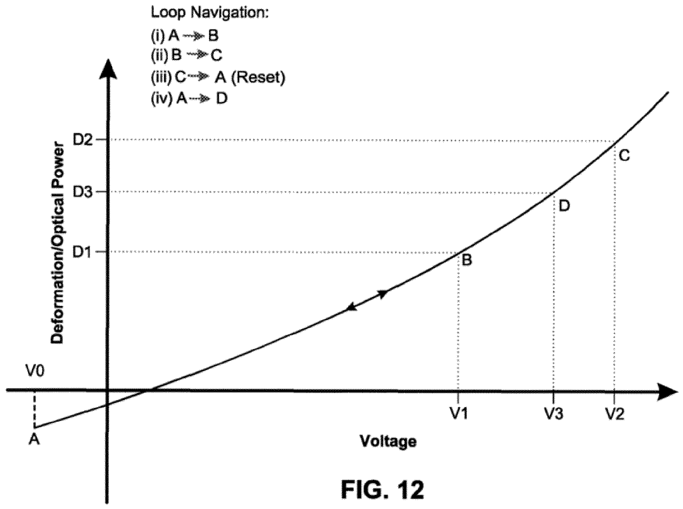

With reference to FIG. 12, shown is a portion of a major hysteresis loop. During operation of a piezoelectric actuator-controlled tunable lens using a reset paradigm, from point A, traveling along the major loop, the application of a positive applied voltage V1 may induce a deformation D1 associated with point B. From point B, and continuing along the major loop, the application of a positive voltage V2 may induce a deformation D2 (associated with point C). From point C, a decrease in the applied voltage to a reset value V0 may precede the application of a positive voltage V3 to induce a deformation D3 associated with point D.

In accordance with some embodiments, a method may include applying a first driving voltage to a piezoelectric actuator to generate a first optical power in a tunable lens, applying a second driving voltage greater than the first driving voltage to generate a second optical power in the tunable lens, where the second optical power is greater than the first optical power, applying a reset voltage less than the first driving voltage to reset the tunable lens, and applying a third driving voltage less than the second driving voltage to generate a third optical power in the tunable lens. The third optical power may be less than the second optical power and, in some examples, the third optical power may be less than the first optical power. As used herein, applying a reset voltage may include applying zero volts or a negative voltage to the piezoelectric actuator.

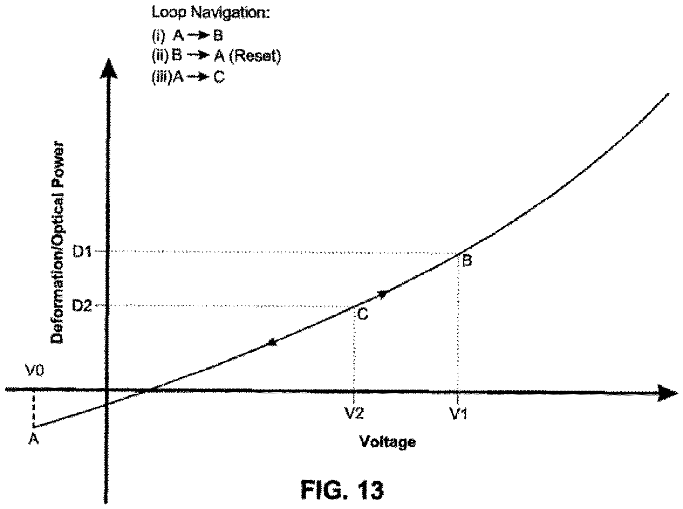

With reference to FIG. 13, shown is a portion of a further major hysteresis loop. During operation of a piezoelectric actuator-controlled tunable lens using a reset paradigm, from point A, traveling along the major loop, the application of a positive applied voltage V1 may induce a deformation D1 associated with point B. From point B, a decrease in the applied voltage to a reset value V0 may precede the application of a positive voltage V2 to induce a deformation D2 associated with point C. Voltage V2 may be less than voltage V1 and deformation D2 may be less than deformation D1.

Accordingly, a further method may include applying a first driving voltage to a piezoelectric actuator to generate a first optical power in the tunable lens, applying a reset voltage less than the first driving voltage to reset the tunable lens, and applying a second driving voltage to the piezoelectric actuator to generate a second optical power in the tunable lens, where the second driving voltage is less than the first driving voltage.

Disclosed is a system and method for the controllable and reproducible operation of a tunable lens, and more specifically to the implementation of a unified model for addressing various sources of non-linearity with such operation, including hysteresis, thermal drift, creep, and inter device variability in as-manufactured optical power. The capacitance of a piezoelectric actuator may be measured real-time to provide closed-loop control of the optical power of the lens.

### Example Embodiments

Example 1: A method includes determining a relationship between the optical power of a tunable lens and the capacitance of a piezoelectric element configured to deform the tunable lens, measuring the capacitance of the piezoelectric element, and applying a driving voltage to the piezoelectric element based on the measured capacitance to induce a desired optical power in the tunable lens.

Example 2: The method of Example 1, where determining the relationship between the optical power and the capacitance includes evaluating at least two conditions selected from an initial optical power of the tunable lens, piezoelectric hysteresis of the piezoelectric element, thermal drift of the optical power, and viscoelastic creep of a component of the tunable lens.

Example 3: The method of any of Examples 1 and 2, including applying a sensing voltage to the piezoelectric element while applying the driving voltage.

Example 4: The method of any of Examples 1-3, where applying the driving voltage includes applying a first driving voltage to the piezoelectric element to generate a first optical power in the tunable lens, applying a reset voltage less than the first driving voltage to the piezoelectric element to reset the tunable lens, and applying a second driving voltage less than the first driving voltage to the piezoelectric element to generate a second optical power in the tunable lens.

Example 5: The method of any of Examples 1-3, where applying the driving voltage includes applying a first driving voltage to the piezoelectric element to generate a first optical power in the tunable lens, applying a second driving voltage greater than the first driving voltage to the piezoelectric element to generate a second optical power in the tunable lens, applying a reset voltage less than the first driving voltage to the piezoelectric element to reset the tunable lens, and applying a third driving voltage less than the second driving voltage to the piezoelectric element to generate a third optical power in the tunable lens.

Example 6: A method includes applying a first driving voltage to a piezoelectric element to generate a first optical power in a tunable lens, applying a reset voltage less than the first driving voltage to the piezoelectric element to reset the tunable lens, and applying a second driving voltage to the piezoelectric element to generate a second optical power in the tunable lens, wherein the second driving voltage is less than the first driving voltage.

Example 7: The method of Example 6, where applying the reset voltage includes applying zero volts or a negative voltage to the piezoelectric element.

Example 8: The method of any of Examples 6 and 7, where the first optical power is less than the second optical power.

Example 9: The method of any of Examples 6-8, including applying a sensing voltage to the piezoelectric element while applying the first driving voltage and the second driving voltage.

Example 10: The method of any of Examples 6-9, including sensing a capacitance of the piezoelectric element.

Example 11: The method of any of Examples 6-10, where the first and second driving voltages are determined from respective capacitance measurements of the piezoelectric element.

Example 12: A method includes applying a first driving voltage to a piezoelectric element to generate a first optical power in a tunable lens, applying a second driving voltage greater than the first driving voltage to the piezoelectric element to generate a second optical power in the tunable lens, applying a reset voltage less than the first driving voltage to the piezoelectric element to reset the tunable lens, and applying a third driving voltage less than the second driving voltage to the piezoelectric element to generate a third optical power in the tunable lens.

Example 13: The method of Example 12, where applying the reset voltage includes applying zero volts or a negative voltage to the piezoelectric element.

Example 14: The method of any of Examples 12 and 13, where the third driving voltage is greater than the first driving voltage.

Example 15: The method of any of Examples 12-14, where the second optical power is greater than the first optical power.

Example 16: The method of any of Examples 12-15, where the third driving voltage is less than the second driving voltage.

Example 17: The method of any of Examples 12-16, where the third driving voltage is less than the first driving voltage.

Example 18: The method of any of Examples 12-17, including applying a sensing voltage to the piezoelectric element while applying the first driving voltage, the second driving voltage, and the third driving voltage.

Example 19: The method of any of Examples 12-18, including sensing a capacitance of the piezoelectric element.

Example 20: The method of any of Examples 12-19, where the first, second, and third driving voltages are determined from respective capacitance measurements of the piezoelectric element.

Some portions of this description may describe embodiments in terms of algorithms and symbolic representations of operations on information. These operations, while described functionally, computationally, or logically, are understood to be implemented by computer programs or equivalent electrical circuits, microcode, or the like. Furthermore, it has also proven convenient at times, to refer to these arrangements of operations as modules, without loss of generality. The described operations and their associated modules may be embodied in software, firmware, hardware, or any combinations thereof.

Any of the steps, operations, or processes described herein may be performed or implemented with one or more hardware or software modules, alone or in combination with other devices. In some embodiments, a software module may be implemented with a computer program product including a computer-readable medium containing computer program code, which can be executed by a computer processor for performing any or all the steps, operations, or processes described.

Embodiments may also relate to an apparatus for performing the operations herein. This apparatus may be specially constructed for the required purposes, and/or it may include a general-purpose computing device selectively activated or reconfigured by a computer program stored in the computer. Such a computer program may be stored in a non-transitory, tangible computer readable storage medium, or any type of media suitable for storing electronic instructions, which may be coupled to a computer system bus. Furthermore, any computing systems referred to herein may include a single processor or architectures employing multiple processor designs for increased computing capability.

Embodiments may also relate to a product that is produced by a computing process described herein. Such a product may include information resulting from a computing process, where the information is stored on a non-transitory, tangible computer readable storage medium and may include any embodiment of a computer program product or other data combination described herein.

Embodiments of the present disclosure may include or be implemented in conjunction with various types of artificial-reality systems. Artificial reality is a form of reality that has been adjusted in some manner before presentation to a user, which may include, for example, a virtual reality, an augmented reality, a mixed reality, a hybrid reality, or some combination and/or derivative thereof. Artificial-reality content may include completely computer-generated content or computer-generated content combined with captured (e.g., real-world) content. The artificial-reality content may include video, audio, haptic feedback, or some combination thereof, any of which may be presented in a single channel or in multiple channels (such as stereo video that produces a three-dimensional (3D) effect to the viewer). Additionally, in some embodiments, artificial reality may also be associated with applications, products, accessories, services, or some combination thereof, that are used to, for example, create content in an artificial reality and/or are otherwise used in (e.g., to perform activities in) an artificial reality.

Artificial-reality systems may be implemented in a variety of different form factors and configurations. Some artificial-reality systems may be designed to work without near-eye displays (NEDs). Other artificial-reality systems may include an NED that also provides visibility into the real world (e.g., augmented-reality system 1400 in FIG. 14) or that visually immerses a user in an artificial reality (e.g., virtual-reality system 1500 in FIG. 15). While some artificial-reality devices may be self-contained systems, other artificial-reality devices may communicate and/or coordinate with external devices to provide an artificial-reality experience to a user. Examples of such external devices include handheld controllers, mobile devices, desktop computers, devices worn by a user, devices worn by one or more other users, and/or any other suitable external system.

Turning to FIG. 14, augmented-reality system 1400 may include an eyewear device 1402 with a frame 1410 configured to hold a left display device 1415(A) and a right display device 1415(B) in front of a user's eyes. Display devices 1415(A) and 1415(B) may act together or independently to present an image or series of images to a user. While augmented-reality system 1400 includes two displays, embodiments of this disclosure may be implemented in augmented-reality systems with a single NED or more than two NEDs.

In some embodiments, augmented-reality system 1400 may include one or more sensors, such as sensor 1440. Sensor 1440 may generate measurement signals in response to motion of augmented-reality system 1400 and may be located on substantially any portion of frame 1410. Sensor 1440 may represent a position sensor, an inertial measurement unit (IMU), a depth camera assembly, a structured light emitter and/or detector, or any combination thereof. In some embodiments, augmented-reality system 1400 may or may not include sensor 1440 or may include more than one sensor. In embodiments in which sensor 1440 includes an IMU, the IMU may generate calibration data based on measurement signals from sensor 1440. Examples of sensor 1440 may include, without limitation, accelerometers, gyroscopes, magnetometers, other suitable types of sensors that detect motion, sensors used for error correction of the IMU, or some combination thereof.

Augmented-reality system 1400 may also include a microphone array with a plurality of acoustic transducers 1420(A)-1420(J), referred to collectively as acoustic transducers 1420. Acoustic transducers 1420 may be transducers that detect air pressure variations induced by sound waves. Each acoustic transducer 1420 may be configured to detect sound and convert the detected sound into an electronic format (e.g., an analog or digital format). The microphone array in FIG. 14 may include, for example, ten acoustic transducers: 1420(A) and 1420(B), which may be designed to be placed inside a corresponding ear of the user, acoustic transducers 1420(C), 1420(D), 1420(E), 1420(F), 1420(G), and 1420(H), which may be positioned at various locations on frame 1410, and/or acoustic transducers 1420(I) and 1420(J), which may be positioned on a corresponding neckband 1405.

In some embodiments, one or more of acoustic transducers 1420(A)-(F) may be used as output transducers (e.g., speakers). For example, acoustic transducers 1420(A) and/or 1420(B) may be earbuds or any other suitable type of headphone or speaker.

The configuration of acoustic transducers 1420 of the microphone array may vary. While augmented-reality system 1400 is shown in FIG. 14 as having ten acoustic transducers 1420, the number of acoustic transducers 1420 may be greater or less than ten. In some embodiments, using higher numbers of acoustic transducers 1420 may increase the amount of audio information collected and/or the sensitivity and accuracy of the audio information. In contrast, using a lower number of acoustic transducers 1420 may decrease the computing power required by an associated controller 1450 to process the collected audio information. In addition, the position of each acoustic transducer 1420 of the microphone array may vary. For example, the position of an acoustic transducer 1420 may include a defined position on the user, a defined coordinate on frame 1410, an orientation associated with each acoustic transducer 1420, or some combination thereof.

Acoustic transducers 1420(A) and 1420(B) may be positioned on different parts of the user's ear, such as behind the pinna, behind the tragus, and/or within the auricle or fossa. Or, there may be additional acoustic transducers 1420 on or surrounding the ear in addition to acoustic transducers 1420 inside the ear canal. Having an acoustic transducer 1420 positioned next to an ear canal of a user may enable the microphone array to collect information on how sounds arrive at the ear canal. By positioning at least two of acoustic transducers 1420 on either side of a user's head (e.g., as binaural microphones), augmented-reality device 1400 may simulate binaural hearing and capture a 3D stereo sound field around about a user's head. In some embodiments, acoustic transducers 1420(A) and 1420(B) may be connected to augmented-reality system 1400 via a wired connection 1430, and in other embodiments acoustic transducers 1420(A) and 1420(B) may be connected to augmented-reality system 1400 via a wireless connection (e.g., a Bluetooth connection). In still other embodiments, acoustic transducers 1420(A) and 1420(B) may not be used at all in conjunction with augmented-reality system 1400.

Acoustic transducers 1420 on frame 1410 may be positioned along the length of the temples, across the bridge, above or below display devices 1415(A) and 1415(B), or some combination thereof. Acoustic transducers 1420 may be oriented such that the microphone array is able to detect sounds in a wide range of directions surrounding the user wearing the augmented-reality system 1400. In some embodiments, an optimization process may be performed during manufacturing of augmented-reality system 1400 to determine relative positioning of each acoustic transducer 1420 in the microphone array.

In some examples, augmented-reality system 1400 may include or be connected to an external device (e.g., a paired device), such as neckband 1405. Neckband 1405 generally represents any type or form of paired device. Thus, the following discussion of neckband 1405 may also apply to various other paired devices, such as charging cases, smart watches, smart phones, wrist bands, other wearable devices, hand-held controllers, tablet computers, laptop computers, other external compute devices, etc.

As shown, neckband 1405 may be coupled to eyewear device 1402 via one or more connectors. The connectors may be wired or wireless and may include electrical and/or non-electrical (e.g., structural) components. In some cases, eyewear device 1402 and neckband 1405 may operate independently without any wired or wireless connection between them. While FIG. 14 illustrates the components of eyewear device 1402 and neckband 1405 in example locations on eyewear device 1402 and neckband 1405, the components may be located elsewhere and/or distributed differently on eyewear device 1402 and/or neckband 1405. In some embodiments, the components of eyewear device 1402 and neckband 1405 may be located on one or more additional peripheral devices paired with eyewear device 1402, neckband 1405, or some combination thereof.

Pairing external devices, such as neckband 1405, with augmented-reality eyewear devices may enable the eyewear devices to achieve the form factor of a pair of glasses while still providing sufficient battery and computation power for expanded capabilities. Some or all of the battery power, computational resources, and/or additional features of augmented-reality system 1400 may be provided by a paired device or shared between a paired device and an eyewear device, thus reducing the weight, heat profile, and form factor of the eyewear device overall while still retaining desired functionality. For example, neckband 1405 may allow components that would otherwise be included on an eyewear device to be included in neckband 1405 since users may tolerate a heavier weight load on their shoulders than they would tolerate on their heads. Neckband 1405 may also have a larger surface area over which to diffuse and disperse heat to the ambient environment. Thus, neckband 1405 may allow for greater battery and computation capacity than might otherwise have been possible on a stand-alone eyewear device. Since weight carried in neckband 1405 may be less invasive to a user than weight carried in eyewear device 1402, a user may tolerate wearing a lighter eyewear device and carrying or wearing the paired device for greater lengths of time than a user would tolerate wearing a heavy standalone eyewear device, thereby enabling users to more fully incorporate artificial-reality environments into their day-to-day activities.

Neckband 1405 may be communicatively coupled with eyewear device 1402 and/or to other devices. These other devices may provide certain functions (e.g., tracking, localizing, depth mapping, processing, storage, etc.) to augmented-reality system 1400. In the embodiment of FIG. 14, neckband 1405 may include two acoustic transducers (e.g., 1420(I) and 1420(J)) that are part of the microphone array (or potentially form their own microphone subarray). Neckband 1405 may also include a controller 1425 and a power source 1435.

Acoustic transducers 1420(I) and 1420(J) of neckband 1405 may be configured to detect sound and convert the detected sound into an electronic format (analog or digital). In the embodiment of FIG. 14, acoustic transducers 1420(I) and 1420(J) may be positioned on neckband 1405, thereby increasing the distance between the neckband acoustic transducers 1420(I) and 1420(J) and other acoustic transducers 1420 positioned on eyewear device 1402. In some cases, increasing the distance between acoustic transducers 1420 of the microphone array may improve the accuracy of beamforming performed via the microphone array. For example, if a sound is detected by acoustic transducers 1420(C) and 1420(D) and the distance between acoustic transducers 1420(C) and 1420(D) is greater than, e.g., the distance between acoustic transducers 1420(D) and 1420(E), the determined source location of the detected sound may be more accurate than if the sound had been detected by acoustic transducers 1420(D) and 1420(E).

Controller 1425 of neckband 1405 may process information generated by the sensors on neckband 1405 and/or augmented-reality system 1400. For example, controller 1425 may process information from the microphone array that describes sounds detected by the microphone array. For each detected sound, controller 1425 may perform a direction-of-arrival (DOA) estimation to estimate a direction from which the detected sound arrived at the microphone array. As the microphone array detects sounds, controller 1425 may populate an audio data set with the information. In embodiments in which augmented-reality system 1400 includes an inertial measurement unit, controller 1425 may compute all inertial and spatial calculations from the IMU located on eyewear device 1402. A connector may convey information between augmented-reality system 1400 and neckband 1405 and between augmented-reality system 1400 and controller 1425. The information may be in the form of optical data, electrical data, wireless data, or any other transmittable data form. Moving the processing of information generated by augmented-reality system 1400 to neckband 1405 may reduce weight and heat in eyewear device 1402, making it more comfortable to the user.

Power source 1435 in neckband 1405 may provide power to eyewear device 1402 and/or to neckband 1405. Power source 1435 may include, without limitation, lithium ion batteries, lithium-polymer batteries, primary lithium batteries, alkaline batteries, or any other form of power storage. In some cases, power source 1435 may be a wired power source. Including power source 1435 on neckband 1405 instead of on eyewear device 1402 may help better distribute the weight and heat generated by power source 1435.

As noted, some artificial-reality systems may, instead of blending an artificial reality with actual reality, substantially replace one or more of a user's sensory perceptions of the real world with a virtual experience. One example of this type of system is a head-worn display system, such as virtual-reality system 1500 in FIG. 15, that mostly or completely covers a user's field of view. Virtual-reality system 1500 may include a front rigid body 1502 and a band 1504 shaped to fit around a user's head. Virtual-reality system 1500 may also include output audio transducers 1506(A) and 1506(B). Furthermore, while not shown in FIG. 15, front rigid body 1502 may include one or more electronic elements, including one or more electronic displays, one or more inertial measurement units (IMUs), one or more tracking emitters or detectors, and/or any other suitable device or system for creating an artificial reality experience.

Artificial-reality systems may include a variety of types of visual feedback mechanisms. For example, display devices in augmented-reality system 1400 and/or virtual-reality system 1500 may include one or more liquid crystal displays (LCDs), light emitting diode (LED) displays, organic LED (OLED) displays, digital light project (DLP) micro-displays, liquid crystal on silicon (LCoS) micro-displays, and/or any other suitable type of display screen. Artificial-reality systems may include a single display screen for both eyes or may provide a display screen for each eye, which may allow for additional flexibility for varifocal adjustments or for correcting a user's refractive error. Some artificial-reality systems may also include optical subsystems having one or more lenses (e.g., conventional concave or convex lenses, Fresnel lenses, adjustable liquid lenses, etc.) through which a user may view a display screen. These optical subsystems may serve a variety of purposes, including to collimate (e.g., make an object appear at a greater distance than its physical distance), to magnify (e.g., make an object appear larger than its actual size), and/or to relay (to, e.g., the viewer's eyes) light. These optical subsystems may be used in a non-pupil-forming architecture (such as a single lens configuration that directly collimates light but results in so-called pincushion distortion) and/or a pupil-forming architecture (such as a multi-lens configuration that produces so-called barrel distortion to nullify pincushion distortion).

In addition to or instead of using display screens, some artificial-reality systems may include one or more projection systems. For example, display devices in augmented-reality system 1400 and/or virtual-reality system 1500 may include micro-LED projectors that project light (using, e.g., a waveguide) into display devices, such as clear combiner lenses that allow ambient light to pass through. The display devices may refract the projected light toward a user's pupil and may enable a user to simultaneously view both artificial-reality content and the real world. The display devices may accomplish this using any of a variety of different optical components, including waveguide components (e.g., holographic, planar, diffractive, polarized, and/or reflective waveguide elements), light-manipulation surfaces and elements (such as diffractive, reflective, and refractive elements and gratings), coupling elements, etc. Artificial-reality systems may also be configured with any other suitable type or form of image projection system, such as retinal projectors used in virtual retina displays.

Artificial-reality systems may also include various types of computer vision components and subsystems. For example, augmented-reality system 1400 and/or virtual-reality system 1500 may include one or more optical sensors, such as two-dimensional (2D) or 3D cameras, structured light transmitters and detectors, time-of-flight depth sensors, single-beam or sweeping laser rangefinders, 3D LiDAR sensors, and/or any other suitable type or form of optical sensor. An artificial-reality system may process data from one or more of these sensors to identify a location of a user, to map the real world, to provide a user with context about real-world surroundings, and/or to perform a variety of other functions.

Artificial-reality systems may also include one or more input and/or output audio transducers. In the examples shown in FIG. 15, output audio transducers 1506(A) and 1506(B) may include voice coil speakers, ribbon speakers, electrostatic speakers, piezoelectric speakers, bone conduction transducers, cartilage conduction transducers, tragus-vibration transducers, and/or any other suitable type or form of audio transducer. Similarly, input audio transducers may include condenser microphones, dynamic microphones, ribbon microphones, and/or any other type or form of input transducer. In some embodiments, a single transducer may be used for both audio input and audio output.

While not shown in FIG. 14, artificial-reality systems may include tactile (i.e., haptic) feedback systems, which may be incorporated into headwear, gloves, body suits, handheld controllers, environmental devices (e.g., chairs, floormats, etc.), and/or any other type of device or system. Haptic feedback systems may provide various types of cutaneous feedback, including vibration, force, traction, texture, and/or temperature. Haptic feedback systems may also provide various types of kinesthetic feedback, such as motion and compliance. Haptic feedback may be implemented using motors, piezoelectric actuators, fluidic systems, and/or a variety of other types of feedback mechanisms. Haptic feedback systems may be implemented independent of other artificial-reality devices, within other artificial-reality devices, and/or in conjunction with other artificial-reality devices.

By providing haptic sensations, audible content, and/or visual content, artificial-reality systems may create an entire virtual experience or enhance a user's real-world experience in a variety of contexts and environments. For instance, artificial-reality systems may assist or extend a user's perception, memory, or cognition within a particular environment. Some systems may enhance a user's interactions with other people in the real world or may enable more immersive interactions with other people in a virtual world. Artificial-reality systems may also be used for educational purposes (e.g., for teaching or training in schools, hospitals, government organizations, military organizations, business enterprises, etc.), entertainment purposes (e.g., for playing video games, listening to music, watching video content, etc.), and/or for accessibility purposes (e.g., as hearing aids, visual aids, etc.). The embodiments disclosed herein may enable or enhance a user's artificial-reality experience in one or more of these contexts and environments and/or in other contexts and environments.

The process parameters and sequence of the steps described and/or illustrated herein are given by way of example only and can be varied as desired. For example, while the steps illustrated and/or described herein may be shown or discussed in a particular order, these steps do not necessarily need to be performed in the order illustrated or discussed. The various exemplary methods described and/or illustrated herein may also omit one or more of the steps described or illustrated herein or include additional steps in addition to those disclosed.

The preceding description has been provided to enable others skilled in the art to best utilize various the exemplary embodiments disclosed herein. This exemplary description is not intended to be exhaustive or to be limited to any precise form disclosed. The embodiments disclosed herein should be considered in all respects illustrative and not restrictive. Reference should be made to the appended claims and their equivalents in determining the scope of the present disclosure.

Unless otherwise noted, the terms "connected to" and "coupled to" (and their derivatives), as used in the specification and claims, are to be construed as permitting both direct and indirect (i.e., via other elements or components) connection. In addition, the terms "a" or "an," as used in the specification and claims, are to be construed as meaning "at least one of." Finally, for ease of use, the terms "including" and "having" (and their derivatives), as used in the specification and claims, are interchangeable with and have the same meaning as the word "comprising."

It will be understood that when an element such as a layer or a region is referred to as being formed on, deposited on, or disposed "on" or "over" another element, it may be located directly on at least a portion of the other element, or one or more intervening elements may also be present. In contrast, when an element is referred to as being "directly on" or "directly over" another element, it may be located on at least a portion of the other element, with no intervening elements present.

As used herein, the term "approximately" in reference to a particular numeric value or range of values may, in certain embodiments, mean and include the stated value as well as all values within 10% of the stated value. Thus, by way of example, reference to the numeric value "50" as "approximately 50" may, in certain embodiments, include values equal to 50±5, i.e., values within the range 45 to 55.

As used herein, the term "substantially" in reference to a given parameter, property, or condition may mean and include to a degree that one of ordinary skill in the art would understand that the given parameter, property, or condition is met with a small degree of variance, such as within acceptable manufacturing tolerances. By way of example, depending on the particular parameter, property, or condition that is substantially met, the parameter, property, or condition may be at least approximately 90% met, at least approximately 95% met, or even at least approximately 99% met.

While various features, elements or steps of particular embodiments may be disclosed using the transitional phrase "comprising," it is to be understood that alternative embodiments,
including those that may be described using the transitional phrases "consisting of" or "consisting essentially of," are implied. Thus, for example, implied alternative embodiments to
a piezoelectric element that comprises or includes lead zirconate titanate (PZT) include embodiments where a piezoelectric element consists essentially of lead zirconate titanate and embodiments where a piezoelectric element consists of lead zirconate titanate.

## Claims

1. A method comprising:
determining a relationship between the optical power of a tunable lens and the capacitance of a piezoelectric element configured to deform the tunable lens;
measuring the capacitance of the piezoelectric element; and
applying a driving voltage to the piezoelectric element based on the measured capacitance to induce a desired optical power in the tunable lens.

2. The method of claim 1, wherein determining the relationship between the optical power and the capacitance comprises evaluating at least two conditions selected from the group consisting of an initial optical power of the tunable lens, piezoelectric hysteresis of the piezoelectric element, thermal drift of the optical power, and viscoelastic creep of a component of the tunable lens.

3. The method of claim 1 or claim 2, comprising applying a sensing voltage to the piezoelectric element while applying the driving voltage.

4. The method of any preceding claim, wherein applying the driving voltage comprises:
applying a first driving voltage to the piezoelectric element to generate a first optical power in the tunable lens;
applying a reset voltage less than the first driving voltage to the piezoelectric element to reset the tunable lens; and
applying a second driving voltage less than the first driving voltage to the piezoelectric element to generate a second optical power in the tunable lens.

5. The method of any of claims 1 to 3, wherein applying the driving voltage comprises:
applying a first driving voltage to the piezoelectric element to generate a first optical power in the tunable lens;
applying a second driving voltage greater than the first driving voltage to the piezoelectric element to generate a second optical power in the tunable lens; applying a reset voltage less than the first driving voltage to the piezoelectric element to reset the tunable lens; and
applying a third driving voltage less than the second driving voltage to the piezoelectric element to generate a third optical power in the tunable lens.

6. A method comprising:
applying a first driving voltage to a piezoelectric element to generate a first optical power in a tunable lens;
applying a reset voltage less than the first driving voltage to the piezoelectric element to reset the tunable lens; and
applying a second driving voltage to the piezoelectric element to generate a second optical power in the tunable lens, wherein the second driving voltage is less than the first driving voltage.

7. The method of claim 6, wherein:
applying the reset voltage comprises applying zero volts or a negative voltage to the piezoelectric element, and/or
the first optical power is less than the second optical power.

8. The method of claim 6 or claim 7, comprising:
applying a sensing voltage to the piezoelectric element while applying the first driving voltage and the second driving voltage, and/or
sensing a capacitance of the piezoelectric element.

9. The method of any of claims 6 to 8, wherein the first and second driving voltages are determined from respective capacitance measurements of the piezoelectric element.

10. A method comprising:
applying a first driving voltage to a piezoelectric element to generate a first optical power in a tunable lens;
applying a second driving voltage greater than the first driving voltage to the piezoelectric element to generate a second optical power in the tunable lens;
applying a reset voltage less than the first driving voltage to the piezoelectric element to reset the tunable lens; and
applying a third driving voltage less than the second driving voltage to the piezoelectric element to generate a third optical power in the tunable lens.

11. The method of claim 10, wherein applying the reset voltage comprises applying zero volts or a negative voltage to the piezoelectric element.

12. The method of claim 10 or claim 11, wherein:
the third driving voltage is greater than the first driving voltage, and/or
the third driving voltage is less than the second driving voltage.

13. The method of any of claims 10 to 12, wherein:
the second optical power is greater than the first optical power, and/or
the third optical power is less than the first optical power.

14. The method of any of claims 10 to 13, comprising:
applying a sensing voltage to the piezoelectric element while applying the first driving voltage, the second driving voltage, and the third driving voltage, and/or
sensing a capacitance of the piezoelectric element.

15. The method of any of claims 10 to 14, wherein the first, second, and third driving voltages are determined from respective capacitance measurements of the piezoelectric element.
